# EUROPEAN PATENT SPECIFICATION

(11) **EP 0 311 077 B1**
(45) Date of publication and mention of the grant of the patent: **30.08.1995**
(21) Application number: 88116573.2
(22) Date of filing: 06.10.1988
(51) Int. Cl.: H01L 21/00, H05K 13/08

(54) **Apparatus and method for feeding and positioning articles being processed**
Vorrichtung umd Verfahren zum Zuführen und Positionieren von zu behandelnden Gegenständen
Appareil et méthode d'amenée et de positionnement d'objets à traiter

(30) Priority: 06.10.1987 JP 252198/87
(43) Date of publication of application: 12.04.1989
(73) Proprietor: KABUSHIKI KAISHA TOSHIBA, Kawasaki-shi, Kanagawa-ken 210 (JP)
(72) Inventor: Kobayashi, Hiroaki, Yokohama-shi Kanagawa-ken (JP); Nagaoka, Masahito, Kawasaki-shi Kanagawa-ken (JP)
(74) Representative: Lehn, Werner, Dipl.-Ing.

(56) References cited:
- US-A- 3 603 728
- US-A- 4 505 225
- US-A- 4 674 670

## Description

### BACKGROUND OF THE INVENTION

This invention relates generally to means for feeding and positioning articles undergoing processing relative to the means carrying out the processing. More particularly, the invention relates to a system for feeding and positioning articles which is designed to carry out with high precision positioning of articles such as lead frames in the fabrication and assembly of semiconductor devices.

In general, the process of assembling a semiconductor device comprises the steps of mounting a semiconductor chip on a lead frame, carrying out wire bonding with respect to this semiconductor chip thus mounted, and setting this semiconductor chip thus wire bonded in a metal mold. In carrying out these steps, a lead frame is fed along guide rails, and, at each work position, it is required that the lead frame be positioned and stopped accurately and positively.

In order to feed and position the lead frame, it has been the practice to form pilot holes at constant spacing intervals along a lateral side part of the lead frame in the longitudinal direction thereof and to cause a pilot pin to engage with each pilot hole thereby to achieve positioning.

In this known technique, however, pilot pins respectively suitable for a variety of lead frames of different frame widths and feed pitches become necessary, whereby the pilot pin must be changed for every frame, and assembly efficiency drops. See US-A-4674670 for an example of this technique.

For this reason, we have proposed a system (as disclosed in Japanese Patent Application Laid-Open Publication No. 81634/1986) in which: a lead frame is moved through only a set distance; the actual lead frame feed quantity is detected at every completion of the movement; the (error) difference between this detected quantity and a specified lead frame feed quantity is measured by means such as an ITV camera; and the difference thus measured is used as feedback to correct the lead frame feed quantity of the succeeding feeding, whereby the necessity of using pilot pins is obviated.

In another prior-art technique (as disclosed in Japanese Patent Application Laid-Open Publication No. 80231/1985), positioning of a lead frame is accomplished by using an image sensor. More specifically, the positional difference or offset between the detection position and the center position of the island of the lead frame is detected by an image sensor, and the lead frame is moved by a distance corresponding to this positional offset thereby to accomplish correction.

However, in the above described positioning techniques in which pilot pins are unnecessary, it has been heretofore necessary to either use a pattern-recognition ITV camera having the object of pattern recognition of chip mounts, wire bonding, etc., or to use separate ITV cameras. In either case, time for pattern recognition becomes necessary and gives rise to a decrease in cycle time. Moreover, pattern recognition entails a program of relatively high level, the control of which occupies a large proportion thereof, whereby not only does a control system of extensive scale become necessary, but, for adaptability to a large variety of articles, a memory capacity for storing corresponding patterns becomes necessary. Furthermore, in pattern recognition, a pattern of a configuration which is appropriate for the lead frame is required, and its size must match the image size of the ITV camera.

In the above described example of the prior art, an X-Y table is caused to move, and an appropriate shape in the vicinity of the inner lead is made the objective. However, not only does a movement time become necessary, but the inner lead is readily deformed, whereby there arises the problem of uncertainty of reliability of this as a datum reference. While a pilot hole is suitable as a datum reference, it is accompanied by a number of problems such as the great length of the movement distance and the addition of the movement time. Furthermore, the size of a pilot hole is of the order of 1 to 2 mm and does not match the ITV camera in some cases, and, even if it does match, memory means for a great variety of patterns becomes necessary.

The use of separate ITV cameras for respectively exclusive use may appear to be feasible, but it has been accompanied in all instances by the problem of high costs and the problem of excessive installation space due to the positioning above of the head of the chip mounting mechanism and of the head of the wire bonding mechanism and other parts and to the positioning below of a wafer ring, heater, etc.

### SUMMARY OF THE INVENTION

Accordingly, it is an object of this invention to provide a system for feeding and positioning articles undergoing processing in which the problems accompanying like systems in the prior art are solved, and, in the conveying and positioning of lead frames or other articles, this positioning can be carried out accurately, positively, and at high speed, and which is adaptable to various sizes and shapes of articles and contributes to low-cost fabrication of products.

According to this invention there is provided an apparatus for feeding and positioning articles being processed as given in claim 1. Also provided is a method of feeding articles as given in claim 6.

According to this invention, by counting by means of a counter the quantity of feeding of an article such as a lead frame after the timing at which a part to be detected of the article has passed by a passage detecting sensor of the detection component, setting by means of the feed quantity setting component the feed quantity of the article from this passage timing to the completion of conveying and driving and positioning of the article, and controlling by means of the feed quantity controlling component the conveying device for conveying and driving the article, the article feed quantity from the passage detecting component is continually controlled at a constant value thereby to carry out positioning.

According to this invention as summarized above, instead of using ITV cameras, an inexpensive optical sensor and a mechanical scanning means or the like are combined, and moreover, for this mechanical scanning means, the conveying of the article to be conveyed such as a lead frame, which is the original objective, is utilized. As a result, a performance as high as that resulting from the use of a line sensor can be attained, and there is provided a high-speed feeding and poitioning system the control and mechanism of which are relatively simple and of low equipment cost.

According to this invention, moveover, the problem of articles such as lead frames of different characteristics such as size and shape is solved by the use of varying a few set data without increasing the memory capacity.

According to this invention, furthermore, in the case of a lead frame, for example, there are deviations or irregularities such as dimensional errors and those in the pilot hole diameter and pilot hole position. However, since the center in the feeding direction which is not influenced by these deviations is determined, accurate and positive positioning can be achieved, and at the same time, since pilot holes, which undergo very little deformation due to external forces or heat as areas in the vicinity of the inner leads, are used as datum references, the reliability is also improved.

Since each article such as a lead frame is moved continually in the conveying direction, deleterious influences due to effects such as lost motion and backlash can be eliminated.

The nature, utility, and further features of this invention will be more clearly apparent from the following detailed description with respect to preferred embodiments of the invention when read in conjunction with the accompanying drawings, briefly described below.

### BRIEF DESCRIPTION OF THE DRAWINGS

In the drawings:
FIG. 1 is a combination of a schematic diagram, in side view, and a block diagram showing the essential parts and their organization of one example of the system for feeding and positioning articles according to this invention;
FIG. 2 is a time chart indicating one mode of practice of the system- for feeding and positioning articles of the invention;
FIG. 3 is a plan view of one example of a lead frame of the invention;
FIG. 4 is a time chart indicating a positioning operation which does not form a part of the invention; and
FIG. 5 is a time chart indicating another positioning operation which does not form a part of the invention.

### DETAILED DESCRIPTION OF THE INVENTION

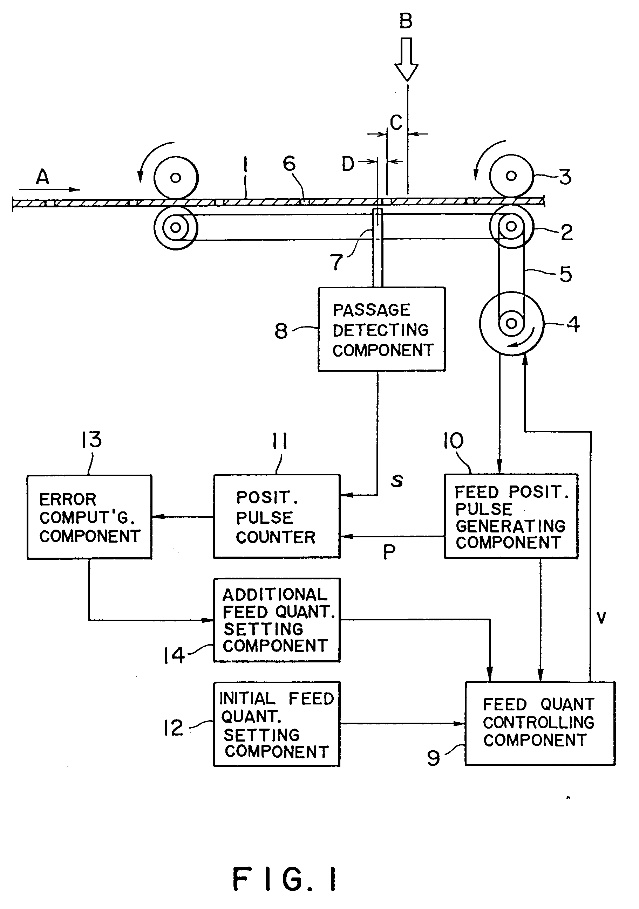

One example of application of the invention to the feeding and positioning of a lead frame is illustrated in FIG. 1, in which the lead frame 1, which is the article being conveyed, is movably clamped between a driving roller 2 and a pinch roller 3. The driving roller 2 is driven in rotation by a motive power motor 4 with an encoder by way of a timing belt 5. The rotary power output of the motor 4 is thus transmitted to cause the driving roller 2 to rotate and thereby to convey the lead frame 1 in the arrow direction A as indicated in FIG. 1.

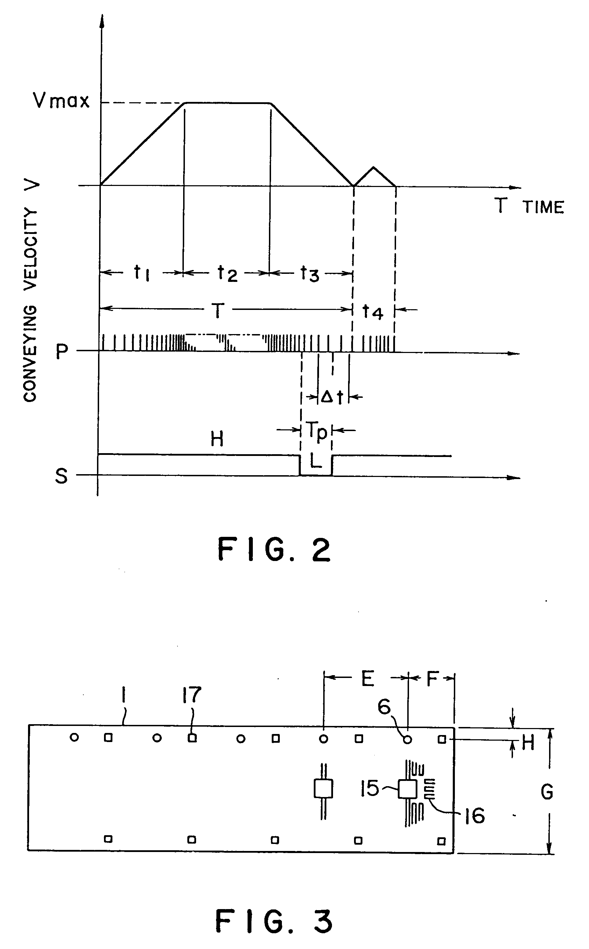

Along a line parallel and close to one lateral edge of the lead frame 1, a row of pilot holes 6, 6, ... are formed at a specific even spacing or pitch. As will be apparent from FIG. 3, these pilot holes 6 are to become datum reference points for respective islands 15 on which semiconductor chips are to be mounted and for inner leads 16. Each pilot hole 6 is set to be aligned in the lateral or transverse direction with the center of a respective island 15, and the pitch dimension between adjacent pilot holes 6 is set at a specific value E.

In FIG. 1, the position indicated by the arrow B is the ultimate objective stopping position relative to the lead frame 1 for carrying out wire bonding. A fiber sensor 7 for detecting the passage of diametrically opposite (downstream and upstream) parts of the rim of each passing pilot hole 6 is disposed on one side of the lead frame 1, in the path of the pilot holes 6, at a point at a distance (C+D) equal to distance C plus distance D upstream, or in the direction opposite to the arrow direction A, from the stopping position B. This fiber sensor 7 is functionally connected to a passage detection component 8, and when it detects the passage of the downstream part of the rim of a pilot hole 6, a passage detection signal S is transmitted from the passage detection component 8 to a position pulse counter 11.

The aforementioned driving motor 4 with an encoder is activated by an input signal from a feed quantity control component 9 to rotate at a velocity v through only a specific rotational angle. The output from the encoder is aligned in a pulse train P corresponding to the frame feed quantity by a feed position pulse generating component 10 and is sent to the position pulse counter 11.

To the above mentioned feed quantity control component 9 is connected an initial feed quantity setting component 12, which inputs into the feed quantity control component 9 a feed quantity of a distance of frame feed quantity E-C which is less than the aforementioned specific pitch E by the above mentioned distance C. The initial feed time T corresponding to the initial feed quantity comprises an acceleration time t₁, a constant velocity time t₂, and a deceleration time t₃. At the maximum velocity Vₘₐₓ, the driving motor 4 is activated, and, at the instant when the pilot hole 6 reaches a point which is in front of the stopping position B by the distance C, the motor 4 stops once, and the lead frame 1 stops.

During the above described process, the position pulse counter 11 counts the number of pulses of a pulse train P₁ corresponding to the feed quantity up to the stopping of the driving of the motor 4 from the timing resulting from inversion of the passage detection signal S from the passage detection component 8, which has detected the other (upstream) part of the rim of the pilot hole 6. In addition, this position pulse counter 11 counts the number of pulses of a pulse train P₂ also similarly from the timing after the detection signal S is inverted on detecting the downstream part of the rim until the motor 4 stops.

The time tₚ required for one pilot hole 6 to travel past a detection point above the aforementioned fiber sensor 7 varies with the feeding speed, the size of the pilot hole 6, the position of the pilot hole 6, and other factors, and, as a consequence of this variation, the above mentioned numbers of pulses in the pulse trains also vary.

The values of the products obtained by multiplying the numbers of pulses P₁ and P₂ of the pulse trains thus counted by the position pulse counter 11 by the feeding quantity per pulse correspond to the distances the pilot hole 6 travels past the fiber sensor 7 from the time when the signal S of the passage detection component 8 is first inverted and the time when it is again inverted, and the value (P₁+P₂)/2 becomes the number of pulses corresponding to the distance D which the center of the pilot hole 6 has traveled past the fiber sensor 7. The product value obtained by multiplying this number of pulses by the above mentioned feeding quantity per pulse becomes the distance D, and the time required for this becomes Δt.

By maintaining the value of the distance C+D constant, positioning is accomplished with good reproducibility at the ultimate objective stopping position B. By arbitrarily setting the distance C through the initial feed quantity setting component 12, an ultimate objective stopping position B can be appropriately set to suit the character of the article being processed and the apparatus.

In carrying out in continuation the feeding of the lead frame 1 through the distance C, the distance D is estimated and set beforehand by an error computing component 13. By determining the difference of error between this preestimated distance D and the distance determined from the number of pulses (P₁+P₂)/2 mentioned hereinabove, the error difference ±ΔD of distance corresponding to this difference of error is determined indirectly. Then, in an additional feed quantity setting component 14, the number of pulses resulting from the addition of this error difference ±ΔD to the distance C is calculated, and feeding through a distance C±ΔD corresponding to this number of pulses thus calculated is carried out, the conveying of the lead frame 1 of the feed quantity C±ΔD being carried out over the additional feed time t₄, whereby the accurate and positive positioning is completed.

In the instant example, with the use of an encoder corresponding to 10 »m/pulse, conveying positioning is carried out at a pulse frequency of maximum velocity 25 kHz, and, with a required time held within 0.4 sec., the conveying positioning of the lead frame 1 can be accomplished accurately and positively even in the case where errors exist in the size and positional dimension H of the pilot hole 6, the width G of the lead frame 1, and the specific pitch E.

In this connection, a system wherein the lead frame 1 is provided, in addition to the pilot holes 6, with square holes 17, for example, which pass over the sensor 7 to cause the detection signal S to be outputted is also conceivable. In this case, however, the time interval T or the frame feed quantity can be limited so that only the pilot holes 6 will be detected, whereby the detection signal S will be received during only a restricted period thereby to solve this problem.

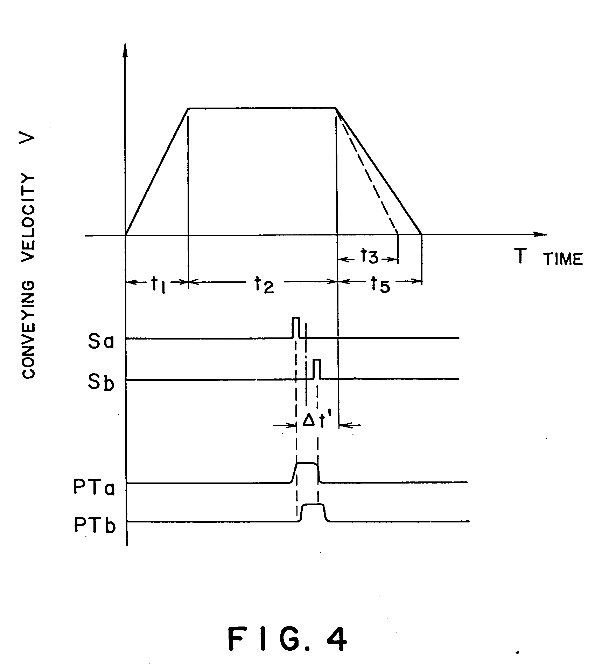

The time chart shown in Fig. 4 is an example in which the lead frame is not stopped until the pertinent pilot hole 6 reaches the objective stopping position. In this example, a conveyance direction two-lens sensor is used for the fiber sensor for detection, and the deviation outputs Sa and Sb wherein the output difference between the phototransistor outputs PTa and PTb of this sensor is a maximum are used as detection signals of the passage detecting component. In general, for reasons of noise resistance, modulated light is used, and, because of restriction of the modulation frequency thereof, there is a limit to the response speed, but a two-lens sensor of deviation output can follow an even higher speed conveyance because modulated light is unnecessary, which is convenient.

The number of pulses from the start of the driving motor to the instant the sensor detects the downstream part of the rim of a pilot hole 6 is designated by Pa, and the number of pulses to the instant when the succeeding (upstream) part of the rim is detected in designated by Pb. Then, the number of pulses up to the center of the pilot hole 6 is equal to Pa + (Pb-Pa)/2. Therefore, by multiplying the number of pulses up to the center of the pilot hole 6 by the distance per pulse to determine the distance up to the center of the pilot hole, and supplying the number of pulses corresponding to the distance from this center to the objective stopping position to the feed quantity controlling component 9, the center of the pilot hole 6 can be set at the objective stopping position.

Positioning is accomplished by conveying the frame through a specific frame feed quantity from the timing of the signals Sa and Sb, and, by increasing/decreasing the feed quantity in the deceleration time t₃ after the time t₂ in which the frame is conveyed at maximum velocity, variations of the time interval Δt′ from the midpoint of the signals Sa and Sb to the instant of completion of the maximum velocity period are disposed of. That is, by the increasing/decreasing of the frame feed quantity, with the timing of the signals Sa and Sb, the feed quantity thereafter is reset and reduced by the feed position pulses after the timing of the signals Sa and Sb, and the feed quantity is determined by the deceleration time of t₃ to t₅ by the number of remaining pulses at the instant of completion of the time interval t₂.

In the above described example, a conveying method utilizing rollers and an encoder is adopted, but this invention can be applied to other arrangements such as a combination of a reciprocating frame clamp and a pulse motor. Furthermore, for the sensor, the application of a laser sensor can be considered, and also a CCD line sensor can be applied. In addition, suitable detectable parts other than pilot holes may be used for detection.

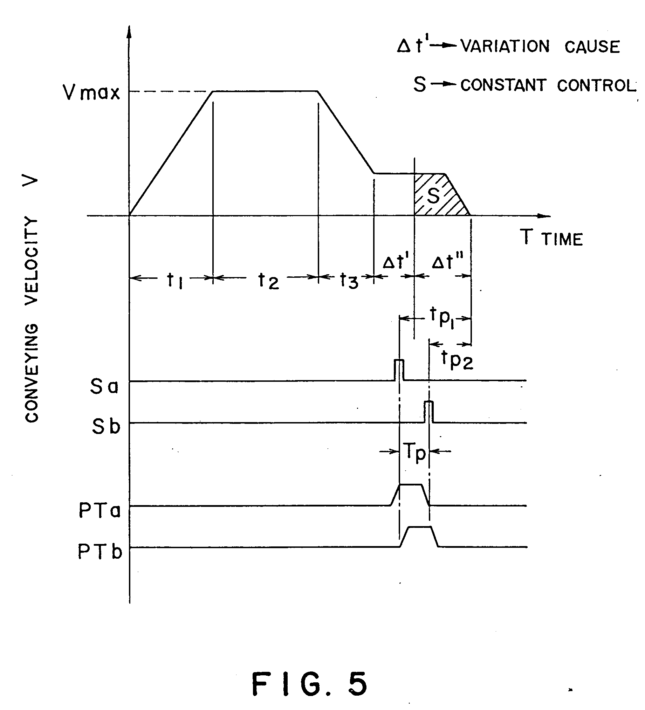

Still another example is indicated in FIG. 5 wherein, in the system indicated in FIG. 4, the conveying velocity Vₘₐₓ of the lead frame is excessively high, and the sensor 7 cannot adequately follow the frame, the conveying velocity of the lead frame is reduced stepwisely, and, in a low-velocity region, passage of the pilot holes is detected.

According to this example, an area S in FIG. 5 which correspond to the distance C is controlled at constant value.

## Claims

1. Apparatus for feeding a succession of articles (1) spaced apart by a pre-selected pitch E, and for positioning a leading article of the succession, the apparatus comprising:
a device (2,3) for feeding said article, and for temporarily stopping said article such that a reference datum (6) on said article is positioned at a temporary stopping position upstream of an ultimate objective stopping position (B);
a passage detecting component (7), for detecting the passage of said reference datum and located at a forward mark point upstream by a specific distance C+D of said ultimate objective stopping position;
a position pulse counter (11) for counting the timing of the passage of said reference datum (6) past said forward mark point;
an initial feed quantity setting component (12) for setting an initial feeding quantity E-C of said article (1) at C less than said pitch E;
an additional feed quantity setting component (14) for setting an additional feeding quantity C of said article (1) up to said ultimate objective stopping position (B) which is calculated in accordance with the distance D between said temporary stopping position and said forward mark point as determined in said position pulse counter (11); and
a feed quantity control component (9) for actuating said conveying device (2, 3) in accordance with said feed quantities thus set.

2. Apparatus as claimed in claim 1 in which the passage detecting component (8) is arranged to detect more than one reference point of said reference datum (6), thereby to determine the location of the temporary stopping position of the reference datum, downstream of the forward mark point.

3. Apparatus as claimed in claim 2 wherein the reference datum (6) is a pilot hole and the position pulse counter (11) is adapted to count a first number of pulses P₁, corresponding to a time period between passage of one rim of said pilot hole (6) and said temporary stop of said article (1), and a second number P₂ of pulses corresponding to a time period between passage of the opposite rim of the pilot hole (6) and said temporary stop of said article (1), and determine the distance between the center of the pilot hole and the forward mark point in accordance with the first and second numbers of pulses.

4. Apparatus as claimed in claim 1, 2 or 3 wherein said additional feed quantity setting component (14) includes means for generating a number of pulses corresponding to the distance between the temporary stopping position and the ultimate objective stopping position (B).

5. Apparatus as claimed in any one of the preceding claims wherein said additional feeding quantity C is said specific distance minus the downstream distance D from the forward mark point to the temporary stopping position.

6. A method of feeding a succession of articles (1) spaced apart by a pre-selected pitch E, and for positioning a leading article of the succession, said method comprising the steps of:
(a) setting an initial feeding quantity E-C for the article (1), said article having a reference datum (6);
(b) feeding said article said initial feeding quantity;
(c) detecting passage of said reference datum past a forward mark point which is at a position at a specific distance C+D upstream of an ultimate objective stopping position (B);
(d) temporarily stopping said article downstream of the forward mark point and upstream of said ultimate objective stopping position;
(e) determining the distance (D) between said reference datum of said article temporarily stopped and said forward mark point;
(f) determining in accordance with said distance detemined in step (e) the additional feeding quantity C for said article to be fed to the said ultimate objective stopping position (B); and
(g) conveying said article said additional feeding quantity up to said ultimate objective stopping position (B).

## Patentansprüche

1. Vorrichtung zum Weitertransportieren einer Abfolge von Artikeln (1), die zueinander in einem vorgewählten Abstand E liegen und zum Positionieren eines führenden Artikels der Abfolge, wobei die Vorrichtung umfaßt:
eine Einrichtung (2, 3) zum Weitertransportieren des Artikels und zum vorübergehenden Stoppen des Artikels, so daß ein Referenzdatenwert (6) des Artikels an einer vorübergehenden Stopposition stromaufwärts einer letzten Zielstopposition (B) positioniert ist;
eine Durchlauf-Erfassungskomponente (7) zum Erfassen des Durchlaufs des Referenzdatenwerts und angeordnet an einem Vorwärtsmarkierungspunkt stromaufwärts in einem vorgegebenen Abstand C+D der letzten Zielstopposition;
einen Positions-Impulszähler (11) zum Zählen der Zeit des Durchgangs des Referenzdatenwerts (6) vorbei an dem Vorwärtsmarkierungspunkt;
eine Anfangstransportgrößen-Einstellkomponente (12) zum Einstellen einer Anfangstransportgröße E-C des Artikels (1) bei C kleiner als der Abstand E;
eine Zusatztransportgrößen-Einstellkomponente (14) zum Einstellen einer zusätzlichen Transportgröße C des Artikels (1) bis zu der letzten Zielstopposition B, die gemäß dem Abstand D zwischen der vorübergehenden Stopposition und dem Vorwärtsmarkierungspunkt wie in dem Positions-Impulszähler (11) bestimmt berechnet wird; und
eine Transportgrößen-Steuerkomponente (9) zum Betätigen der Transporteinrichtung (2, 3) entsprechend der so eingestellten Transportgrößen.

2. Vorrichtung nach Anspruch 1,
wobei die Durchgangs-Erfassungskomponente (8) angeordnet ist, um mehr als einen Referenzpunkt des Referenzdatenwerts (6) zu erfassen, um dadurch die Stelle der vorübergehenden Stopposition des Referenzdatenwerts zu bestimmen, stromabwärts von dem Vorwärtsmarkierungspunkt.

3. Vorrichtung nach Anspruch 2,
dadurch **gekennzeichnet,** daß der Referenzdatenwert (6) ein Führungsloch ist und der Positions-Impulszähler (11) ausgelegt ist zum Zählen einer ersten Anzahl von Impulsen (P₁) entsprechend einer Zeitperiode zwischen einem Durchgang eines Rands des Führungslochs (6) und dem vorübergehenden Stopp des Artikels (1) und einer zweiten Anzahl (P₂) von Impulsen entsprechend einer Zeitperiode zwischen einem Durchgang des gegenüberliegenden Rands des Führungslochs (6) und dem vorübergehenden Stopp des Artikels (1) und zum Bestimmen des Abstands zwischen der Mitte des Führungslochs und dem Vorwärtsmarkierungspunkt entsprechend der ersten und zweiten Anzahlen von Impulsen.

4. Vorrichtung nach Anspruch 1, 2 oder 3,
dadurch **gekennzeichnet,** daß die Zusatztransportgrößen-Einstellkomponente (14) eine Einrichtung umfaßt, zum Erzeugen einer Anzahl von Impulsen entsprechend de Abstand zwischen der vorübergehenden Stopposition und der letzten Zielstopposition (B).

5. Vorrichtung nach einem der vorangehenden Ansprüche,
dadurch **gekennzeichnet,** daß die Zusatztransportgröße C der bestimmte Abstand minus der Abstand D stromabwärts von dem Vorwärtsmarkierungspunkt zu der vorübergehenden Stopposition ist.

6. Verfahren zum Transport einer Abfolge von Artikeln (1), die in einem vorgewählten Abstand E liegen und zum Positionieren eines führenden Artikels der Abfolge, wobei das Verfahren die folgenden Schritte umfaßt:
(a) Einstellen einer Anfangstransportgröße E-C für den Artikel (1), wobei der Artikel einen Referenzdatenwert (6) aufweist;
(b) Transportieren des Artikels mit der Anfangstransportgröße;
(c) Erfassen eines Durchgangs des Referenzdatenwerts vorbei an einem Vorwärtsmarkierungspunkt, der an einer Position in einem bestimmten Abstand C+D stromaufwärts von einer letzten Zielstopposition (B) ist;
(d) vorübergehendes Stoppen des Artikels stromabwärts von dem Vorwärtsmarkierungspunkt und stromaufwärts von der letzten Zielstopposition;
(e) Bestimmen des Abstands D zwischen dem Referenzdatenwert des vorübergehenden gestoppten Artikels und dem Vorwärtsmarkierungspunkt;
(f) Bestimmen entsprechend dem in Schritt (e) bestimmten Abstand der Zusatztransportgröße C für den an die letzte Zielstopposition (B) zu transportierenden Artikel; und
(g) Weitertransportieren des Artikels mit der Zusatztransportgröße bis zu der letzten Zielstopposition (B).

## Revendications

1. Appareil pour amener une suite d'objets (1) séparés d'un espacement E sélectionné à l'avance, et pour positionner un objet de tête de la suite, l'appareil comprenant:
un dispositif (2, 3) pour amener ledit objet, et pour arrêter temporairement ledit objet, de façon qu'un repère de référence (6) dudit objet soit placé dans une position d'arrêt temporaire en amont d'une position d'arrêt finale objectif (B);
un composant de détection de passage (7), pour détecter le passage dudit repère de référence, et situé en un point de marquage avant, à une distance spécifique C+D en amont de ladite position d'arrêt finale objectif;
un compteur d'impulsions de position (11) pour compter le minutage du passage dudit repère de référence (6) au-delà dudit point de marquage avant;
un composant de réglage de valeur d'amenée initiale (12), pour régler une valeur d'amenée initiale E-C dudit objet (1), à C de moins que ledit espacement E;
un composant de réglage de valeur d'amenée supplementaire (14), pour régler une valeur d'amenée supplémentaire C dudit objet (1), jusqu'à ladite position d'arrêt finale objectif (B), qui est calculée en fonction de la distance D entre ladite position d'arrêt temporaire et ledit point de marquage avant, comme déterminé dans ledit compteur d'impulsions de position (11); et
un composant de contrôle de valeur d'amenée (9), pour actionner ledit dispositif d'amenée (2, 3) en fonction desdites valeurs d'amenée ainsi réglées.

2. Appareil selon la revendication 1, dans lequel le composant de détection de passage (8) est aménagé pour détecter plus d'un point de référence dudit repère de référence (6), de façon a déterminer l'emplacement de la position d'arrêt temporaire du repère de référence, en aval du point de marquage avant.

3. Appareil selon la revendication 2, dans lequel le repère de référence (6) est un trou pilote, et le compteur d'impulsions de position (11) est susceptible de compter un premier nombre d'impulsions Pᵢ, correspondant à la durée entre le passage d'un bord dudit trou pilote (6) et ledit arrêt temporaire dudit objet (1), et un second nombre d'impulsions P₂ correspondant à la durée entre le passage du bord opposé dudit trou pilote (6) et ledit arrêt temporaire dudit objet (1), et de déterminer la distance entre le centre du trou pilote et le point de marquage avant, en fonction du premier et du second nombres d'impulsions.

4. Appareil selon la revendication 1, 2 ou 3, dans lequel ledit composant de réglage de valeur d'amenée supplémentaire (14) comporte des moyens pour générer un nombre d'impulsions correspondant à la distance entre la position d'arrêt temporaire et la position d'arrêt finale objectif (B).

5. Appareil selon l'une quelconque des revendications précédentes, dans lequel ladite valeur d'amenée supplementaire C est égale à ladite distance spécifique moins la distance aval D entre le point de marquage avant et la position d'arrêt temporaire.

6. Procédé pour amener une suite d'objets (1) séparés d'un espacement E sélectionné à l'avance, et pour positionner un objet de tête de la suite, ledit procédé comprenant les étapes de:
(a) réglage d'une valeur d'amenée initiale E-C pour l'objet (1), ledit objet ayant un repère de référence (6);
(b) amenée dudit objet de ladite valeur d'amenée initiales;
(c) détection du passage dudit repère de référence au-delà d'un point de marquage avant, qui se trouve dans une position située à une distance spécifique C+D en amount d'une position d'arrêt finale objectif (B);
(d) arrêt temporaire dudit objet en aval du point de marquage avant, et en amont de ladite position d'arrêt finale objectif;
(e) détermination de la distance (D) entre ledit repère de référence dudit objet temporairement arrêté et ledit point de marquage avant;
(f) détermination en fonction de ladite distance déterminée à l'étape (e), de la valeur d'amenée supplémentaire C pour que ledit objet soit amené dans ladite position d'arrêt finale objectif (B); et
(g) acheminement dudit objet de ladite valeur d'amenée supplémentaire, jusqu'à ladite position d'arrêt finale objectif (B).
